(19) Europäisches Patentamt

European Patent Office

Office européen des brevets

(11) EP 0 522 614 B1

(12) EUROPEAN PATENT SPECIFICATION

(45) Date of publication and mention
of the grant of the patent:
06.08.1997 Bulletin 1997/32

(51) Int Cl.6: G01R 31/26

(21) Application number: 92201674.6

(22) Date of filing: 10.06.1992

(54) **Method of determining an electrical spectrum**

Verfahren zum Bestimmen eines elektrischen Spektrums

Méthode pour déterminer un spectre électrique

(84) Designated Contracting States:
AT BE CH DE DK ES FR GB GR IT LI LU NL PT SE

(30) Priority: 25.06.1991 NL 9101103

(43) Date of publication of application:
13.01.1993 Bulletin 1993/02

(73) Proprietor: Koninklijke PTT Nederland N.V.
2509 CH Den Haag (NL)

(72) Inventor: van den Brink, Robertus Francisus
Maria
NL-2331 NV Leiden (NL)

(56) References cited:
• ELECTRONICS, vol. 50, no. 8, 14th April 1977,
page 126; J.A. KUZDRALL: "Measure
photovoltaic-diode resistance at zero bias"
• NACHRICHTENTECH., ELEKTRON., vol. 37, no.
8, 1987, pages 291-293, Berlin, DE; B.
KAUFHOLD: "Messtechnische Untersuchungen
zum Signal- und Rausch-Verhalten von
optischen Empfängerschaltungen"
• INTERNATIONALE ELEKTRONISCHE
RUNDSCHAU, vol. 27, no. 2, February 1973,
pages 33-36; W.D. SCHLEIFER: "Stabilitäts- und
Rauschmessungen an Messsendern"

## Description

The invention relates to a method of determining an electrical noise spectrum.

A known way of measuring a spectrum is an absolute measurement with the aid of, for example, a frequency-selective voltmeter or a spectrum analyser. A disadvantageous of this is that the sensitivity of such instruments is in general dependent upon the frequency of the signal presented, with the result that, for an accurate measurement, use has to be made of very accurate, and therefore expensive, instruments.

It is an object of the invention, inter alia, to provide a method as defined in the preamble, which method can be performed with relatively simple means which do not have to be exceptionally accurate.

Thereto, the method according to the invention is characterised in that

- an electrical response spectrum of an optical reference detector illuminated by a light beam is compared with an electrical reference noise spectrum of an electrical noise source for at least two different light intensities of the light beam,
- direct current components of signals generated in the optical reference detector and in an optical detector are measured in order to determine with the aid of the compared spectra the electrical noise spectrum of the optical detector, and
- the electrical noise spectrum to be determined is derived from an electrical response spectrum of the optical detector illuminated by the light beam for the at least two different light intensities of the light beam and the electrical noise spectrum of the optical detector.

Due to this two-stage method, which is based upon ratios, an electrical noise spectrum can be determined with relatively simple means which do not have to be exceptionally accurate.

A first embodiment of the method according to the invention is characterised in that the electrical noise spectrum is an equivalent noise spectrum of an optical receiver including the optical detector.

A second embodiment of the method according to the invention is characterised in that the light beam is generated by a homodyne sweeper.

A third embodiment of the method according to the invention is characterised in that the first light intensity is essentially equal to 100% and the second light intensity is essentially equal to 0%.

A fourth embodiment of the method according to the invention is characterised in that the light beam is alternately fed to the optical detector and to the optical reference detector.

A fifth embodiment of the method according to the invention is characterised in that the electrical reference noise spectrum is a thermal noise spectrum.

A sixth embodiment of the method according to the invention is characterised in that the electrical reference noise spectrum is a shot noise spectrum.

From "Measure photovoltaic-diode resistance at zero bias", by James A. Kuzdrall, Electronics, April 14, 1977, Vol. 50, No. 8, page 126, a photodiode noise-measurement circuit is known for determining the equivalent noise resistance of the photodiode by using a formulae $R_x=R_1*V_0^2/(V_c^2-V_0^2)$, where $V_0$ is an output voltage with a switch open and $V_c$ is an output voltage with the switch closed. The two-stage method according to the invention which uses in each stage two different light intensities for illuminating the optical reference detector and the optical detector is not known from this prior art.

Further embodiments, aspects and advantages will be discussed in the description given below, of the figures, wherein:

Figure 1 illustrates diagrammatically the inventive insight according to the invention;
Figure 2 shows diagrammatically a preferred circuit diagram for standardising a light source by means of the inventive insight according to the invention; and
Figure 3 shows diagrammatically a preferred circuit diagram for performing measurements on an optical receiver.

The invention is primarily based on the insight that it is possible to determine an unknown frequency spectrum of a first noise signal S1 by expressing it in the frequency spectrum of a second noise signal S2 if said signals are fed to an input of an amplifier A. In this case, no particularly accurate and/or expensive equipment is necessary, but it is possible to make do with measuring the output signal of the amplifier A with the aid of a relatively simple measuring instrument M, for example a spectrum analyser or a selective volt-meter.

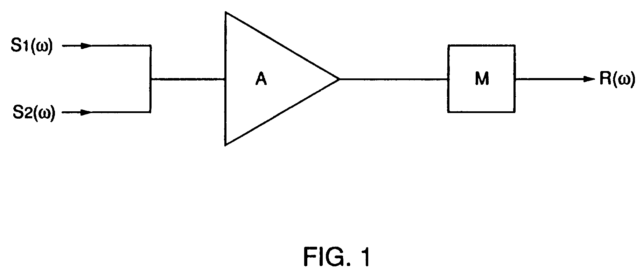

To illustrate this insight, reference is made to Figure 1, in which S1(w) and S2(w) denote the strength of the signal components having frequency w. R denotes the output signal of the amplifier A as reproduced by the measuring instrument M, and R(w) is the strength of the output signal component having frequency w.

The electrical output signal R satisfies the formula

$$R(W) = [S1(w) \oplus S2(w)] \times A(w) \times B(w) \tag{1}$$

where A(w) denotes the (unknown) frequency-dependent gain factor of the preamplifier A at the frequency w (it also being possible for w to have the value 0), where B(w) denotes the (unknown) frequency-dependent gain factor of the measuring instrument M used, at the frequency w, when receiving a broadband input signal, and where the operation "S1(w) $\oplus$ S2(w)" denotes a frequency-wise combination of the two signals S1 and S2, which combination will not in general be a pure addition. It is pointed out that said frequency-wise combination is a statistically determined result of a time-averaged combination of two noise signals and is therefore present as an intrinsic property in the amplifier A and in general can be approximated to a good degree by the formula

$$S1(w) \oplus S2(w) = \sqrt{S1(w)^2 + S2(w)^2} \tag{2}$$

Hereinafter it is assumed that the frequency spectrum of the signal S2 is known. A first measurement is made in a situation in which a predetermined fraction K1 of the signal S1 is fed to the input of the amplifier A along with a predetermined fraction K2 of the signal S2 in order to deliver a test signal which satisfies the formula

$$R1(w) = [K1 \times S1(w) \oplus K2 \times S2(w)] \times A(w) \times B(w) \tag{3}$$

A second measurement is made in a situation in which a predetermined fraction K3 of the signal S1 is fed to the input of the amplifier A together with a predetermined fraction K4 of the signal S2 in order to deliver a test signal which satisfies the formula

$$R2(w) = [K3 \times S1(w) \oplus K4 \times S2(w)] \times A(w) \times B(w) \tag{4}$$

Dividing the formulae (3) and (4) eliminates the characteristics of the amplifier A and of the measuring instrument M used, and the unknown signal S1 can be expressed in the signal S2 in accordance with the formula:

$$\frac{R1(w)}{R2(w)} = \frac{K1 \times S1(w) \oplus K2 \times S2(w)}{K3 \times S1(w) \oplus K4 \times S2(w)} \tag{5}$$

In an embodiment in which K1 = K2 = K4 = 1 and K3 = 0, by substituting formula (2) in formula (5), the unknown signal S1 can be expressed in the known signal S2 and the test signals R1(w) and R2(w) in accordance with the formula:

$$S1(w) = S2(w) \times \sqrt{(\frac{R1(w)}{R2(w)})^2 - 1} \tag{6}$$

In another embodiment in which K1 = K2 = K3 = 1 and K4 = 0, by substituting formula (2) in formula (5), the unknown signal S1 can be expressed in the known signal S2 and the test signals R1(w) and R2(w) in accordance with the formula:

$$S1(w) = S2(w) \times \frac{1}{\sqrt{(\frac{R1(w)}{R2(w)})^2 - 1}} \tag{7}$$

Although separate measurements have been described above, for the sake of clarity, for the signals R1(w) and R2(w) which are divided by one another, it is preferable to make a direct measurement of a signal which is representative of the ratio R1(w)/R2(w), for example by alternately interrupting the signal S1 or S2, which provides an alternating signal strength for every frequency component of the output signal of the test receiver, the ratio of the alternating signal values being representative of said ratio R1(w)/R2(w).

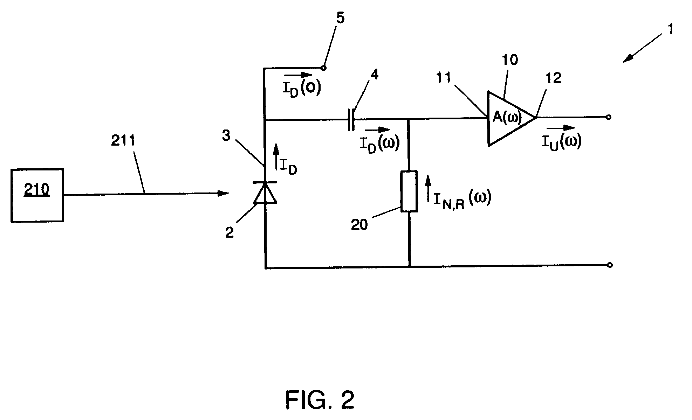

A method of standardising a light source 210 will now be explained in greater detail below by reference to Figure 2, use being made of the insight described above.

The light source 210 produces a light beam 211 which is directed at an optical test detector 2. The optical test detector 2, in the example shown a photosensitive diode, provides at an output 3 an electrical detector signal $I_D$, in the example shown a current signal, whose spectrum is the (as yet unknown) electrical response spectrum of the light source 210.

Preferably, and as shown in Figure 2, the optical test detector 2 forms part of an optical test receiver 1 which comprises, moreover, a preamplifier 10, and the output 3 of the optical test detector 2 is coupled via a capacitor 4 to the input 11 of the preamplifier 10 in order to provide only the alternating-current components $I_D(w)$ of the electrical detector signal $I_D$ at the preamplifier 10. Moreover, the output 3 of the optical test detector 2 is coupled to an output terminal 5 in order to provide the direct-current component $I_D(0)$ of the detector output signal $I_D$. It will be clear that, instead of the capacitor 4, another isolating device can be used to achieve the result that only desired alternating-current components can reach the input 11 of the preamplifier 10. The preamplifier 10 may also be designed to provide only (amplified) alternating-current components at the output 12, while, moreover, the preamplifier 10 may be designed to provide direct-current components at an output (not shown), optionally after amplification.

The input 11 of the preamplifier 10 of the test receiver 1 is coupled to a real source 20 which provides a known electrical noise spectrum $I_{N,R}$ having alternating-current components $I_{N,R}(w)$. In the example shown, the source 20 is a resistor for providing a known noise spectrum determined by thermal effects. An example of an alternative noise source is a photodiode illuminated by an incandescent lamp, which delivers so-called shot noise. In this case it is possible to illuminate the optical test diode 2 itself with an incandescent lamp in order to produce the noise spectrum.

The preamplifier 10 provides an electrical output signal $I_U$ having alternating-current components $I_U(w)$ at an output 12 thereof. Referring to the above discussion of Figure 1 and assuming that the electrical noise components produced by the combination of the test detector 2, the preamplifier 10 and the circuit configuration of the receiver 1 can be neglected when compared with the known noise components $I_{N,R}(w)$ produced by the real source 20 (which assumption is in fact very realistic, in particular, for example, for frequencies lower than 10 MHz), the electrical output signal $I_U$ satisfies the formula (1), where S1 corresponds to $I_D$ and S2 corresponds to $I_{N,R}$.

By performing at least two measurements in which the detector 2 is or is not illuminated with the light from the light source 210, which measurements are preferably performed by alternately interrupting and not interrupting the light beam 211, the electrical response spectrum $I_D$ of the light beam 211 can be expressed according to the invention, by analogy with formula (6), in the known noise signal $I_{N,R}$ of the noise source 20 in accordance with the formula

$$I_D(w) = I_{N,R}(w) \times \sqrt{(\frac{R1(w)}{R2(w)})^2 - 1} \tag{8}$$

Within the scope of the present invention, the term "electrical response spectrum" is understood as meaning the frequency spectrum of the electrical signal which is generated in an optical detector, that is to say an optical/electrical converter, in response to the receipt of the light beam originating from the light source.

The optical detector may be a detector of any type whatsoever, such as, for example, a photocell or a photosensitive diode. In principle, such an optical detector provides a direct-current detector signal at its output, the magnitude of the direct current depending on the intensity of the light received and being virtually independent of the wavelength of the light received within certain limits. The detector signal of the optical detector may also contain alternating-current components, for example as a consequence of a modulation present in the light received or an interference between certain wavelength components of the light beam. A known fact is that various specimens of optical detectors of identical type, for example various specimens of photosensitive diodes, have an identical electrical response on receiving the same optical signal. Within the scope of the present invention, the electrical response spectrum is therefore regarded as a property of the light beam originating from the light source and, since the characteristics of the light beam are determined by the light source, the electrical response spectrum is more particularly regarded, within the scope of the present application, as a property of the light source.

Although various specimens of optical detectors of the same type provide in principle an identical response to the light received from the light source, it may, however, occur in practice that various specimens nevertheless have a different response to the light received. This may be due, for example, to variations in the detector bodies or in the protective materials surrounding the detector bodies or, for example, to varying effects in the light path between the light source and the detector(s) concerned. Such variations can essentially be attributed to variations in the intensity of the light received by the detector, all the wavelength components of the light being varied, at least to a good approximation, to an equal degree, with the consequence that the values of all the components $I_D(w)$ vary to an equal degree, that is to say that the form of the response spectrum remains identical, at least to a good approximation. The curve of the response spectrum F(w) of the spectrum of the signal $I_D$ delivered by the optical detector 2 is therefore now defined as

$$F(w) = \frac{I_D(w)}{I_D(0)} \qquad (9)$$

According to a preferred embodiment of the method according to the invention, the direct-current component $I_D(0)$ is therefore always measured when measuring the alternating-current components $I_D(w)$ as described above, and the alternating-current components $I_D(w)$ are normalised to produce curve components $F(w)$ by dividing them by the direct-current component $I_D(0)$ in accordance with formula (9). In a system which is sufficiently stable with time, it is possible to make do with measuring the direct-current component $I_D(0)$ once and assuming it to be constant.

It is pointed out that, with a suitable design of the light source 210, the spectrum of the signal $I_D$ delivered by the optical detector 2 is flat, that is to say that $F(w) = F$.

An example of a light source which has such a flat spectrum and is therefore preferred is a so-called "homodyne sweeper", for example a "delayed self-homodyne sweeper" comprising a laser, or a "heterodyne sweeper" comprising an LED and a laser. For a detailed description of the operation of a "homodyne sweeper" and the response of a detector to the light emitted by such a light source, reference is made to the paper entitled "Measurement of Frequency Response of Photoreceivers using Self-homodyne Method" by J. Wang et al. in Electronics Letters, 25 May 1989, Vol. 25, No. 11, pages 722-723.

Using a "homodyne sweeper" as light source 210 also achieves the advantage that the electrical response spectrum can be standardised in a relatively large range, for example up to 20 GHz, by only performing measurement in a relatively small frequency range, for example up to 10 MHz. In theory it is even possible to make do with a measurement at only one frequency.

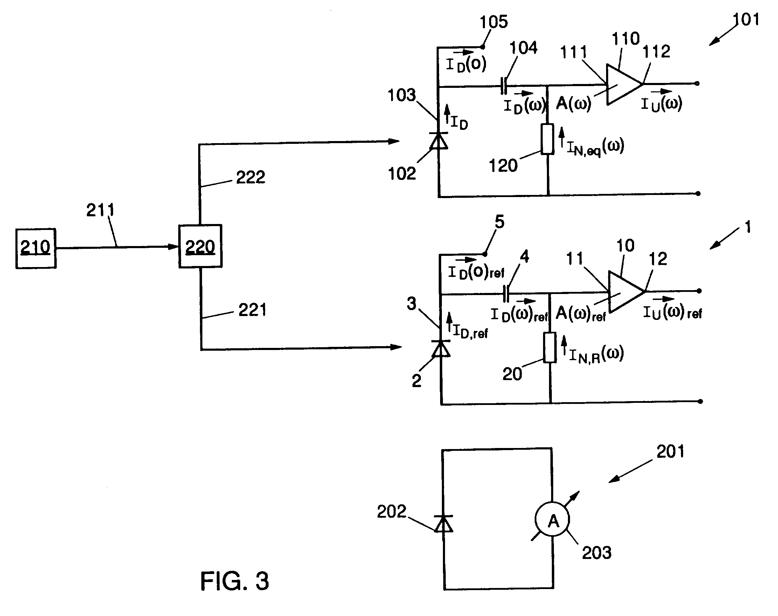

A method of determining the equivalent noise spectrum of an optical receiver will now be explained in greater detail by reference to Figure 3, use being made of the insight described above.

Figure 3 shows diagrammatically an optical receiver 101 to be investigated. The optical receiver 101 comprises an optical detector 102, in the example shown a photosensitive diode. The optical detector 102 provides at an output 103 an electrical detector signal, in the example shown a current signal $I_D$, which corresponds to the light signal received by the optical detector 102. The output 103 of the optical detector 102 is coupled to an input 111 of a preamplifier 110 which has a gain factor $A(w)$ at the frequency w (where w may also have the value 0).

In the example shown, the output 103 of the optical detector 102 is coupled via a capacitor 104 to the input 111 of the preamplifier 110 in order to provide only the alternating-current components $I_D(w)$ of the detector output signal $I_D$ at the preamplifier 110. Moreover, the output 103 of the optical detector 102 is coupled to an output terminal 105 in order to provide the direct-current component $I_D(0)$ of the detector output signal $I_D$. It is emphatically pointed out, however, that the invention also relates to a method of determining the equivalent noise spectrum of an optical receiver in which such an isolation of signal components is not provided, and/or in which no output is present for providing the direct-current component $I_D(0)$ of the detector output signal $I_D$.

If the detector output signal $I_D$ is disregarded, the preamplifier 110 provides, at an output 112 thereof, an electrical noise signal $I_N$ having alternating-current components $I_N(w)$ which is produced in a complex way by the combination of the detector 102, the optional isolating device 104, the preamplifier 110 and the connecting conductors between the detector 102, the optional isolating device 104 and the preamplifier 110. As has already been explained above, an equivalent input noise spectrum $I_{N,eq}$ having alternating-current components $I_{N,eq}(w)$ is defined in accordance with the formula

$$I_{N,eq}(w) = \frac{I_N(w)}{A(w)} \qquad (10)$$

The optical receiver 101 can then be (notionally) regarded as being made up of ideal noise-free components 102, 104 and 110, the input 111 of the preamplifier 110 being connected to a notional noise source 120 which delivers the equivalent noise spectrum $I_{N,eq}$, with the result that the output signal $I_U$ resulting in the operating state at the output 112 of the preamplifier 110 and having alternating-current components $I_U(w)$ is given, analagously to formula (1), by

$$I_U(w) = [I_D(w) \oplus I_{N,eq}(w)] \times A(w) \qquad (11)$$

Moreover, Figure 3 shows diagrammatically a light source 210 which produces a light beam 211. If the light source 210 has already been standardised, the light beam 211 can be fed directly to the detector 102 of the receiver to be investigated. The input signal at the input 111 of the amplifier 110 is then deemed to consist of two signals, namely the unknown equivalent input noise spectrum $I_{N,eq}$ (corresponding to S1) and the output signal $I_D$ of the detector 102 (corresponding to S2), whose spectrum is identical to the known electrical response spectrum of the light beam 211.

As a result of performing at least two measurements in which the detector 102 is and is not illuminated, respectively, with the light from the light source 210, which measurements are preferably alternately performed by interrupting and not interrupting the light beam 211, the equivalent input noise spectrum $I_{N,eq}$ of the optical receiver 101 can, according to the invention, be expressed, by analogy with formula (7) in the known electrical response spectrum $I_D$ of the light beam 211 in accordance with the formula

$$I_{N,eq}(w) = I_D(w) \times \frac{1}{\sqrt{(\frac{R1(w)}{R2(w)})^2 - 1}} \qquad (12)$$

The description below relates to a measurement procedure according to the invention for determining the equivalent input noise spectrum $I_{N,eq}$ of the optical receiver 101 in the case where use is made of an unstandardised light source 210. For this purpose, as is also illustrated in Figure 3, the light beam 211 provided by the light source 210 is split by a splitting device 220 into two light beams 221 and 222 having essentially identical light spectra, one light beam 222 being directed at the optical detector 102 of the receiver 101 to be investigated and the other light beam 221 being directed at an optical detector 2 of a reference receiver 1 which is identical in terms of structure and operation to the optical receiver 1 described above by reference to Figure 2.

Preferably, the splitting device 220 is designed in such a way that the two light beams 221 and 222 have at least essentially equal intensities. For example, the splitting device 220 may comprise a beam splitting prism, or an optical fibre splitting device, or an optical switch, or other suitable means known to persons skilled in the art. Since the specific constructional details of the splitting device 220 are of no importance for a good understanding of the present invention, the splitting device 220 will not be discussed in greater detail here. It is only pointed out that the sole essential requirement which the splitting device 220 must satisfy is that the spectrum of the outgoing light beam 221 and the spectrum of the outgoing light beam 222 are both distorted in the same way with respect to the spectrum of the incoming light beam 211, while the spectra of the outgoing light beams 221 and 222 are preferably identical to the spectrum of the incoming light beam 211, that is to say are not distorted.

An advantage of this is that it is now possible to provide a device for determining a noise spectrum of an optical receiver, which device incorporates a light source 210, a splitting device 220, a reference receiver 1 and at least one measuring instrument which is not specified in greater detail, which device only needs to have one optical output, for example an end of an optical fibre, for delivering the light beam 222, and one electrical input for receiving the receiver output signal $I_U(w)$. At the same time, the splitting device 220 preferably contains an optical switch so as to provide the light beam 211 alternately as light beam 222 to the optical receiver 101 to be investigated and as light beam 221 for the reference receiver 1, an alternating interruption of the light beam for the purpose of the measurements also being provided.

In a particularly advantageous embodiment, the splitting device is provided by causing the light beam 211 to be reflected at a surface of the reference detector which, for this purpose, may have the same construction as a solar cell. In such a reflection, a part of the incident light beam 211 is reflected, with the result that this part is available as output light beam, and another part of the incident light beam 211 enters the reference detector in order to be converted into an electrical signal.

A description will be given below of how the equivalent noise signal $I_{N,eq}(w)$ of the optical receiver 101 to be investigated can be expressed, according to the invention, in the known noise signal $I_{N,R}(w)$ of the noise source 20. In this connection, it is assumed that the measurements on the receivers 1 and 101 have already been performed as described above, the light beams 221 and 222 having been alternately interrupted. Since the light beam 221 represents the "unknown" signal (S1, Figure 1) for the reference receiver 1, formula (6) applies thereto and, in this situation, can be written as

$$I_D(w)_{ref} = I_{N,R}(w) \times \sqrt{(\frac{R1(w)_{ref}}{R2(w)_{ref}})^2 - 1} \qquad (13)$$

From this the following definition is derived:

$$\gamma(w)_{ref} \equiv \frac{I_D(w)_{ref}}{I_{N,R}(w)} = \sqrt{(\frac{R1(w)_{ref}}{R2(w)})^2 - 1} \qquad (14)$$

Moreover, since the light beam 222 represents the "known" signal (S2, Figure 1) for the optical receiver 101 to be investigated, formula (7) is applicable thereto and, in this situation, can be written as

$$I_{N,eq}(w) = I_D(w) \times \frac{1}{\sqrt{(\frac{R1(w)}{R2(w)})^2 - 1}} \qquad (15)$$

From this the following definition is derived:

$$\gamma(w) \equiv \frac{I_D(w)}{I_{N,eq}(w)} = \sqrt{(\frac{R1(w)}{R2(w)})^2 - 1} \qquad (16)$$

The following definition is now made:

$$\alpha(w) = \frac{I_D(w)}{I_D(w)_{ref}} \qquad (17)$$

where the response spectrum ratio characteristic $\alpha(w)$ is the ratio between the detector signals of the optical detectors 2 and 102 and is therefore a measure of, inter alia, the intensity ratio of the beams 221 and 222 and the sensitivity ratio of the optical detectors 2 and 102. In practice, $\alpha(w)$ is constant to a good approximation, that is to say independent of w with the result that

$$\alpha(w) = \alpha \qquad (18)$$

Moreover, a curve parameter V(w) of the spectrum of the signal $I_D$ delivered by the optical detector 102 is defined as

$$V(w) = \frac{I_D(w)}{I_D(w_0)} \qquad (19)$$

where $w_0$ is any freely choosable frequency whatsoever, for example 10 MHz. In that case, the following applies:

$$\frac{\gamma(w)}{\gamma(w_0)_{ref}} = \frac{I_D(w)}{I_D(w_0)_{ref}} \times \frac{I_{N,R}(w_0)}{I_{N,eq}(w)} =$$

$$= \alpha(w_0) \times \frac{I_D(w)}{I_D(w_0)} \times \frac{I_{N,R}(w_0)}{I_{N,eq}(w)} = \alpha \times V(w) \times \frac{I_{N,R}(w_0)}{I_{n,eq}(w)} \rightarrow$$

$$\rightarrow I_{N,eq}(w) = \alpha \times V(w) \times \frac{\gamma(w_0)_{ref}}{\gamma(w)} \times I_{N,R}(w_0) \qquad \textbf{(20)}$$

As has already been pointed out above, with a suitable design of the light source 210, the spectrum of the signal $I_D$ (w) delivered by the optical detector 102 is flat, that is to say that V(w) = 1.

Moreover, it is pointed out that with a correct configuration of the reference receiver 1 and the splitter device 220, namely with a good degree of symmetry between the optical detector 102 and the optical reference detector 2 and with a completely symmetrical beam splitting, $\alpha$ is, to a good approximation, equal to 1. If desired, however, it is possible to measure the value of $\alpha$. The values of the signal components $I_D(w)$ (including $I_D(0)$) are, after all, dependent on the spectrum and the intensity of the light received in such a way that, if the intensity of the light received alters and the spectrum remains otherwise identical, the values of all the components $I_D(w)$ alter to an equal degree. For each light beam 221, 222 and for each frequency w, the ratio $I_D(w)/I_D(0)$ is therefore independent of the intensity of the light received. If the spectrum of the light beam 221 corresponds to the spectrum of the light beam 222, which is assumed according to the above, said ratio for the light beam 222 is equal to that for the light beam 221, that is to say that the following applies:

$$\frac{I_D(w)}{I_D(0)} = \frac{I_D(w)_{ref}}{I_D(0)_{ref}} \qquad (21)$$

which formula can be rewritten as:

$$\frac{I_D(w)}{I_D(w)_{ref}} = \frac{I_D(0)}{I_D(0)_{ref}} = \alpha \qquad (22)$$

If the optical receiver 101 and the optical reference receiver 1 are of the type in which the electrical direct-current components $I_D(0)$ and $I_D(0)_{ref}$ of the signals $I_D$ and $I_{D,ref}$ emitted by the detectors 102 and 2 can be measured directly, the value of $\alpha$ can be determined in a simple way by direct measurement of said electrical direct-current components $I_D(0)$ and $I_D(0)_{ref}$ and dividing them by one another.

As an alternative, for example in the case where the optical receiver 101 to be investigated is of a type in which the electrical direct-current component $I_D(0)$ cannot be measured directly, use can be made of an optical test receiver 201 in measuring the value of $\alpha$. Such a test receiver can consist, in a simple design, of an optical test detector 202 which is identical to the detector 102 to be investigated and which is connected for direct current to an ammeter 203, as is also illustrated in Figure 3. In a separate test stage the light beam 222 is then fed to the optical test detector 202 and the direct-current signal $I_{202}(0)$ which is thereby provided and which, to a good approximation, is equal to the electrical direct-current component $I_D(0)$ of the detector 102 to be investigated on receiving the light beam 222 is measured.

Instead of making use of a separate optical test receiver 201, it is also possible to feed the light beam 222 to the reference receiver 1.

It will be clear that the measurements on the reference receiver and the manipulation of the measurement results to obtain formula (18) only relate to the combination of light source 210, splitting device 220 and reference receiver 1, with the result that said measurements do not always have to be repeated in determining a noise spectrum of different optical receivers. However, preference is in fact given to the repetition of said measurements in order to eliminate any external effects such as temperature effects.

It is pointed out that the method according to the invention is not limited to optical receivers which are provided with a photocell or a photosensitive diode, although such a detector has been mentioned as an example of an optical detector above. The invention also relates to any other type whatsoever of optical detector, the sole requirement imposed on the latter being that the response characteristic (that is to say: the magnitude of the output signal as a function of the wavelength of the light received) is known, or is comparable at least for different specimens of the same type.

Moreover, it is pointed out that a person skilled in the art can modify the embodiment described of the invention without departing from the scope of the invention. Thus, for example, in determining the electrical response spectrum of the light source using the reference receiver, the noise signal of the known noise source can be operated at a first or a second level respectively, which, if the known noise source comprises a photodiode illuminated by an incandescent lamp to provide shot noise, can be achieved in a simple way by operating said incandescent lamp alternately at a first or a second light level, respectively, for example by switching said incandescent lamp alternately on and off, or, alternatively, alternately interrupting the light provided thereby.

Finally, it is pointed out that in determining the equivalent noise spectrum in accordance with formula (20), the actual standardisation of the light source is omitted.

## Claims

1.  Method of determining an electrical noise spectrum, characterised in that

    -   an electrical response spectrum of an optical reference detector (2) illuminated by a light beam (211, 221) is compared with an electrical reference noise spectrum of an electrical noise source (20) for at least two different light intensities of the light beam (211, 221),
    -   direct current components ($I_D$, $I_{D,ref}$) of signals generated in the optical reference detector (2) and in an optical detector (102) are measured in order to determine with the aid of the compared spectra the electrical noise spectrum of the optical detector (102), and

- the electrical noise spectrum to be determined is derived from an electrical response spectrum of the optical detector (102) illuminated by the light beam (211, 221) for the at least two different light intensities of the light beam (211, 221) and the electrical noise spectrum of the optical detector (102).

2. Method according to claim 1, characterised in that the electrical noise spectrum is an equivalent noise spectrum of an optical receiver (101) including the optical detector (102).

3. Method according to claim 1 or 2, characterised in that the light beam (211) is generated by a homodyne sweeper.

4. Method according to claim 3, characterised in that the first light intensity is essentially equal to 100% and the second light intensity is essentially equal to 0%.

5. Method according to claim 3, characterised in that the light beam (211) is alternately fed to the optical detector (102) and to the optical reference detector (2).

6. Method according to claim 3, 4 or 5, characterised in that the electrical reference noise spectrum is a thermal noise spectrum.

7. Method according to claim 3, 4 or 5, characterised in that the electrical reference noise spectrum is a shot noise spectrum.

**Patentansprüche**

1. Verfahren zur Bestimmung eines elektrischen Rauschspektrums, dadurch gekennzeichnet,

- dass ein elektrisches Antwortspektrum eines optischen Referenzdetektors (2), der von einem Lichtstrahl (211, 221) beleuchtet wird, mit einem elektrischen Referenzrauschspektrum einer elektrischen Rauschquelle (20) für mindestens zwei unterschiedliche Lichtintensitäten des Lichtstrahles (211, 221) verglichen wird,
- dass Gleichstromanteile ($I_D$, $I_{D,ref}$) der in dem optischen Referenzdetektor (2) und in einem optischen Detektor (102) erzeugten Signale gemessen werden, um mit der Hilfe der verglichenen Spektren das elektrische Rauschspektrum des optischen Detektors (102) zu bestimmen, und
- dass das zu bestimmende elektrische Rauschspektrum von einem elektrischen Antwortspektrum des optischen Detektors (102), der von dem Lichtstrahl (211, 221) mit den mindestens zwei verschiedenen Lichtintensitäten des Lichtstrahles (211, 221) erleuchtet wird, und dem elektrischen Rauschspektrum des optischen Detektors (102) abgeleitet wird.

2. Verfahren nach Anspruch 1, dadurch gekennzeichnet, dass das elektrische Rauschspektrum ein äquivalentes Rauschspektrum eines optischen Empfängers (101) ist, der den optischen Detektor (102) umfasst.

3. Verfahren nach Anspruch 1 oder Anspruch 2, dadurch gekennzeichnet, dass der Lichtstrahl (211) durch einen homodynen Abtaster erzeugt wird.

4. Verfahren nach Anspruch 3, dadurch gekennzeichnet, dass die erste Lichtintensität im wesentlichen 100 Prozent ist und dass die zweite Lichtintensität im wesentlichen 0 Prozent ist.

5. Verfahren nach Anspruch 3, dadurch gekennzeichnet, dass der Lichtstrahl (211) wechselweise dem optischen Detektor (102) und dem optischen Referenzdetektor (2) zugeführt wird.

6. Verfahren nach einem der Ansprüche 3, 4 oder 5, dadurch gekennzeichnet, dass das elektrische Referenzrauschspektrum ein thermisches Rauschspektrum ist.

7. Verfahren nach einem der Ansprüche 3, 4 oder 5, dadurch gekennzeichnet, dass das elektrische Referenzrauschspektrum ein thermisches Schrotrauschspektrum ist.

**Revendications**

1. Procédé de détermination d'un spectre électrique de bruit, caractérisé en ce que :

   - un spectre électrique de réponse d'un détecteur optique de référence (2) éclairé par un faisceau de lumière (211, 221) est comparé à un spectre de bruit électrique de référence d'une source de bruit électrique (20) pour au moins deux intensités différentes de lumière du faisceau de lumière (211, 221);
   - des composantes de courant continu ($I_D$, $I_{D,ref}$) des signaux générés dans le détecteur optique de référence (2) et dans un détecteur optique (102) sont mesurées de façon à déterminer, à l'aide des spectres comparés, le spectre de bruit électrique du détecteur optique (102); et
   - le spectre de bruit électrique à déterminer est déduit d'un spectre de réponse électrique du détecteur optique (102) éclairé par le faisceau de lumière (211, 221) pour au moins deux intensités différentes de lumière du faisceau de lumière (211, 221), et du spectre de bruit électrique du détecteur optique (102).

2. Procédé selon la revendication 1, caractérisé en ce que le spectre de bruit électrique est un spectre de bruit équivalent d'un récepteur optique (101) comprenant le détecteur optique (102).

3. Procédé selon la revendication 1 ou 2, caractérisé en ce que le faisceau de lumière (211) est généré par un générateur de balayage homodyne.

4. Procédé selon la revendication 3, caractérisé en ce que la première intensité de lumière est pratiquement égale à 100 % et la seconde intensité de lumière est pratiquement égale à 0 % .

5. Procédé selon la revendication 3, caractérisé en ce que le faisceau de lumière (11) est fourni, de façon alternée, au détecteur optique (102) et au détecteur optique de référence (2).

6. Procédé selon la revendication 3, 4 ou 5 caractérisé en ce que le spectre de bruit électrique de référence est un spectre de bruit thermique.

7. Procédé selon la revendication 3, 4 ou 5 caractérisé en ce que le spectre de bruit électrique de référence est un spectre de bruit par impulsion.

EP 0 522 614 B1

FIG. 1

FIG. 2

FIG. 3

EP 0 522 614 B1